# EUROPÄISCHE PATENTANMELDUNG

(11) **EP 3 696 978 A1**
(43) Veröffentlichungstag der Anmeldung: **19.08.2020**
(21) Anmeldenummer: 19157154.6
(22) Anmeldetag: 14.02.2019
(51) Int. Cl.: H03K 17/082, H03K 17/12

(54) **SCHALTMODUL FÜR EINEN ELEKTRONISCHEN SCHALTER**

(71) Anmelder: Siemens Aktiengesellschaft, 80333 München (DE)
(72) Erfinder: Böke, Willi, 91207 Lauf (DE); Gaudenz, Markus Matthias, 91056 Erlangen (DE)

(57) **Zusammenfassung**

Die Erfindung betrifft ein Schaltmodul (1) und einen elektronischen Schalter (10). Zur Verbesserung des elektronischen Schalters (10) wird vorgeschlagen, dass der elektronische Schalter (10) mindestens zwei Schaltmodule aufweist. Die Schaltmodule (10) weisen dabei einen Halbleiterschalter (2) mit einer Ansteuerschaltung (5), einen Stromsensor (3) und eine Datenschnittstelle (4) zur Verbindung mit einem weiteren Schaltmodul (1) auf, wobei mittels der Ansteuerschaltung (5) in Abhängigkeit von über die Datenschnittstelle ausgetauschten Daten und/oder in Abhängigkeit von Messwerten des Stromsensors (3) der Durchlasswiderstand des Halbleiterschalters (2) veränderbar ist. Bei dem elektronischen Schalter (10) mit mindestens zwei derartigen Schaltmodulen (1) sind die Schaltmodule (1) derart parallel zueinander angeordnet, dass die Halbleiterschalter (2) elektrisch parallel zueinander angeordnet sind und dass ein Strom (i) durch den elektronische Schalter (10) sich auf die Halbleiterschalter (2) der Schaltmodule (1) aufteilt, wobei die Datenschnittstellen (4) der jeweiligen Schaltmodule (1) miteinander verbunden sind, wobei mittels der Ansteuerschaltungen (5) durch Veränderung des jeweiligen Durchlasswiderstands der Halbleiterschalter (2) eine Aufteilung des Stroms (i) durch den elektronischen Schalter (10) auf die Halbleiterschalter (2) beeinflussbar, insbesondere steuerbar und/oder regelbar, ist. Die Erfindung betrifft ferner ein Verfahren zum Betreiben eines derartigen elektronischen Schalters (10).

## Beschreibung

Die Erfindung betrifft ein Schaltmodul und einen elektronischen Schalter. Ferner betrifft die Erfindung ein Verfahren zum Betreiben eines derartigen elektronischen Schalters.

Ein Schalter wird auch als Schaltgeräte bezeichnet. Schalter für hohe Ströme, insbesondere mechanische Schalter, sind aufwendiger in der Herstellung, gerade wenn es sich um Gleichspannungsschalter handelt. Aufgrund der geringen Stückzahlen, die mit der Höhe des zu schaltenden Stroms sinken, sind diese Schalter für hohe Ströme im Vergleich zu kleineren Ausführungen entsprechend überproportional teurer. Dabei werden Schalter heutzutage in erster Linie auf die zu schaltende Last ausgelegt.

Neben den mechanischen Schaltern sind auch elektronische Schalter bekannt. Ein elektronischer Schalter weist einen Halbleiterschalter auf, der den Strom durch den elektronischen Schalter führt oder unterbricht. Diese elektronischen Schalter sind in der Lage, schnell zu schalten.

Große Ströme können durch Parallelschalten von mechanischen Schaltern, beispielsweise durch das betriebsmäßige Schalten von Schützen, beherrscht werden. Allerdings ist dieser Parallelbetrieb heutzutage nicht ohne weitere Maßnahmen möglich. So werden dann für die Schutzfunktion zusätzliche Schutzrelais (Messeinrichtungen und Überwachungen) eingesetzt, die die Schaltgeräte dann kontrollieren. Bei der Parallelschaltung von mechanischen Schaltern sind entsprechend Abschläge (10% bis 30%) für eventuelle Asymmetrien in der Stromverteilung zu berücksichtigen. Eine Parallelschaltung über zwei mechanische Schalter hinaus ist auf Grund der großen Abschläge nicht mehr sinnvoll. Zusätzlich müssen aufwendige Konstruktionen für die Zusammenschaltung der Strombahnen eingesetzt werden, da kleine Schaltgeräte nicht den für den Summenstrom nötigen Querschnitt aufnehmen können. Die einzelnen Leiterzuführungen müssen ebenfalls sehr symmetrisch ausgeführt werden, damit die Stromaufteilung gleichmäßig erfolgt. Gleichzeitig sind hohe Anforderungen an ein synchrones Schalten zu erfüllen, damit es nicht bei einer Schalthandlung zu Überlastungen an einem der parallelen Schaltern kommt.

Halbleiter weisen einen Durchlasswiderstand auf. Das ist ein elektrischer Widerstand zwischen den Schaltanschlüssen des Halbleiters. Fließt ein Strom durch den Halbleiter so entsteht unter anderem aufgrund des Durchlasswiderstands ein Spannungsabfall über den Schaltanschlüssen. Gleichzeitig entstehen aufgrund des Durchlasswiderstands abhängig vom Strom Verluste im Halbleiter.

Die Leistungsfähigkeit eines Schalters bemisst sich daran, welchen Strom der Schalter schalten kann. Je größer der schaltbare Strom desto größer ist die Leistungsfähigkeit des Schalters. Man sagt dazu auch, die Schaltleistung des Schalters ist größer.

Der Erfindung liegt die Aufgabe zugrunde, einen elektronischen Schalter zu verbessern.

Diese Aufgabe wird durch ein Schaltmodul, aufweisend einen Halbleiterschalter mit einer Ansteuerschaltung, einen Stromsensor und eine Datenschnittstelle zur Verbindung mit einem weiteren Schaltmodul gelöst, wobei mittels der Ansteuerschaltung in Abhängigkeit von über die Datenschnittstelle ausgetauschten Daten und/oder in Abhängigkeit von Messwerten des Stromsensors der Durchlasswiderstand des Halbleiterschalters veränderbar ist. Weiter wird diese Aufgabe durch einen elektronischen Schalter mit mindestens zwei derartigen Schaltmodulen gelöst, wobei die Schaltmodule derart parallel angeordnet sind, dass die Halbleiterschalter elektrisch parallel angeordnet sind und dass ein Strom durch den elektronische Schalter sich auf die Halbleiterschalter der Schaltmodule aufteilt, wobei die Datenschnittstellen der jeweiligen Schaltmodule miteinander verbunden sind, wobei mittels der Ansteuerschaltungen durch Veränderung des jeweiligen Durchlasswiderstands der Halbleiterschalter eine Aufteilung des Stroms durch den elektronischen Schalter auf die Halbleiterschalter beeinflussbar, insbesondere steuerbar und/oder regelbar, ist. Diese Aufgabe wird ferner durch ein Verfahren zum Betreiben eines derartigen elektronischen Schalters gelöst, wobei in Abhängigkeit von über die Datenschnittstelle ausgetauschten Daten und/oder in Abhängigkeit von Messwerten der Stromsensoren der Durchlasswiderstand der Halbleiterschalter derart gesteuert oder geregelt wird, dass sich der Strom durch den elektronischen Schalter derart auf die Halbleiterschalter aufteilt, dass die jeweiligen Halbleiterschalter maximal den jeweils zulässigen Strom führen.

Weitere vorteilhafte Ausgestaltungen der Erfindung sind in den abhängigen Ansprüchen angegeben.

Der Erfindung liegt die Erkenntnis zugrunde, dass sich ein elektronischer Schalter besonders günstig herstellen lässt, wenn dieser modular aufgebaut ist. Bei dem modularen Aufbau setzt sich der elektronische Schalter aus einer Parallelschaltung von Schaltmodulen zusammen, wobei jedes Schaltmodul einen Halbleiterschalter aufweist. Der Strom durch den elektronischen Schalter teilt sich dabei auf die parallelen Halbleiterschalter auf.

Die Anzahl der Gleichteile, wie gleichartige Schaltmodule oder gleichartige Komponenten in den Schaltmodulen, wie beispielsweise die Datenschnittstelle oder die Ansteuerschaltung, ist groß und es lassen sich damit elektronische Schalter mit unterschiedlichem Leistungsvermögen auf einfache Weise herstellen. Dazu werden unterschiedlich viele Schaltmodule parallelgeschaltet. Gerade auch elektronischer Schalter mit großen Schaltströmen lassen sich durch den modular aufgebauten elektronischen Schalter kostengünstig realisieren.

Die Parallelschaltung von Schaltmodulen und damit die Parallelschaltung von Halbleiterschaltern wird unter anderem durch eine Datenschnittstelle der Schaltmodule ermöglicht. Über diese Datenschnittstelle tauschen die parallel angeordneten Schaltmodule eine Information über ihren Modulzustand aus. Dies kann beispielsweise eine Information über einen gemessenen Strom, eine Information zu dem Überschreiten eines Grenzwertes, insbesondere das Überschreiten des für den Halbleiterschalter zulässigen Stroms, eine Information über die Auslastung des Halbleiterschalters oder über die Verlustleitung des Halbleiterschalters sein. Diese Information wird dazu genutzt, die Aufteilung des Stroms durch den elektronischen Schalter auf die parallel angeordneten Halbleiterschalter zu beeinflussen. Dazu kann neben der Information oder den Informationen der parallel angeordneten Schaltmodule auch der Strommesswert des eigenen Schaltmoduls herangezogen werden. Die Aufteilung des Stroms des elektronischen Schalters erfolgt durch die Ansteuerschaltungen der jeweiligen Schaltmodule, die den Durchlasswiderstand der einzelnen Halbleiterschalter verändert und damit auch die Aufteilung des Stroms auf die einzelnen Schaltmodule beeinflusst. Damit ist die Aufteilung des Stroms auf die einzelnen Schaltmodule durch die Ansteuerschaltung steuerbar oder regelbar.

Für die Aufteilung des Stroms können unterschiedliche Kriterien zur Anwendung kommen. Durch die Regelung oder Steuerung wird sichergestellt, dass die Aufteilung derart erfolgt, dass keiner der parallel angeordneten Halbleiterschalter mit einem unzulässig hohen Strom belastet wird. Mit anderen Worten wird die Aufteilung so geregelt oder gesteuert, dass der Strom durch den Halbleiterschalter maximal den für diesen Halbleiterschalter maximal zulässigen Wert annimmt und der Halbleiterschalter nicht überlastet wird. Dieser Strom kann vorgegeben werden, beispielsweise aus einem Datenblatt des Halbleiterschalters, oder mit Hilfe eines Modells kontinuierlich berechnet werden, wobei beispielsweise die Verlustleitung oder die Temperatur des Halbleiterschalters eingeht. Darüber hinaus hat es sich als vorteilhaft erwiesen, dass der Strom sich gleichmäßig auf die parallelen Halbleiterschalter aufteilt. Dies ist insbesondere dann vorteilhaft, wenn die Schaltmodule baugleich ausgeführt sind. Dann entspricht die gleichmäßige Aufteilung auch einer gleichmäßigen Belastung der Schaltmodule. Durch den Stromsensor kann eine entsprechende Regelung einfach realisiert werden. Alternativ ist es möglich, den Strom derart aufzuteilen, dass die Verlustleistung in den einzelnen Schaltmodulen gleich ist. Damit ist auch die entstehende Wärme gleichmäßig über die Schaltmodule verteilt und kann einfach an die Umgebung abgegeben werden. Die Gefahr von punktueller Erwärmung, die zur Beschädigung oder zu einer Verkürzung der Lebensdauer einzelner Schaltmodule führen kann, kann durch die gleichmäßige Verlustleistung vermieden werden.

Die Abweichungen aufgrund Unterschiede in den einzelnen parallel angeordneten Halbleiterschaltern und die Unterschiede in den Leitungswiderständen, beispielsweise durch einen unsymmetrischen Aufbau der Verdrahtung, können durch die Steuerung des Durchlassverhaltens der einzelnen Halbleiterschalter ausgeregelt werden. Durch eine entsprechende Regelung oder Steuerung ergibt sich dann die gewünschte Aufteilung des Stroms auf die einzelnen Schaltmodule. Damit ergeben sich keine Asymmetrien bei der Stromaufteilung, so dass keine Abschläge bei der Dimensionierung der Parallelschaltung der Schaltmodule des elektronischen Schalters vorgenommen werden müssen. Durch die Messung der Ströme und den Eingriff der Regelung oder Steuerung auf das Durchlassverhalten können damit auch unterschiedliche Ausführungen mit einer Vielzahl von Schaltmodulen parallelgeschaltet werden. Damit lässt sich auf besonders einfache Weise ein modularer elektronischer Schalter mit nahezu beliebigen Schaltströmen aus der Parallelschaltung von Schaltmodulen herstellen. Um eine hohe Bandbreite von Schaltströmen abzudecken, sind dafür nur ein oder zumindest wenige Schaltmodule mit unterschiedlicher Leistungsfähigkeit des Halbleiterschalters erforderlich.

Bei Vorliegen eines Fehlers können die parallel angeordneten Halbleiterschalter mittels der Ansteuerschaltung synchron abgeschaltet werden, um eine Überlastung eines oder mehrerer Schaltmodule zu verhindern. Dabei kann es vorteilhaft sein, zwischen den beiden Schaltzuständen EIN und AUS des Schalters, einen dritten Zustand vorzusehen, bei dem der Schalter bei einem Wechsel zwischen EIN und AUS sowie einem Wechsel zwischen AUS und EIN kurzfristig, d.h. im Zeitbereich von bis zu 1ms, im linearen Bereich betrieben wird. Dadurch kann der aufgeteilte Strom durch die einzelnen Schaltmodule kontrolliert reduziert oder kontrolliert aufgebaut werden. Eine Überlastung hervorgerufen durch eine geänderte Stromaufteilung aufgrund eines zeitlich versetzten Schaltens der einzelnen parallel angeordneten Halbleiterschalter wird damit zuverlässig vermieden. Als besonders vorteilhaft hat sich dabei eine Zeitdauer von 1µs bis 10ps als vorteilhaft herausgestellt, um eine Überlastung einzelner parallel angeordneter Halbleiterschalter zu vermeiden und gleichzeitig den verlustbehafteten Betrieb im linearen Bereich möglichst kurz zu gestalten.

Gegenüber einer Parallelschaltung von elektromechanischen Schaltgeräten kann bei dem elektronischen Schalter auf der Basis von parallel angeordneten Schaltmodulen durch die kontinuierliche Beeinflussung des Durchlassverhaltens der einzelnen Halbleiterschalter eine günstige Ausnutzung und sogar eine maximale Ausnutzung aller parallelgeschalteter Schaltmodule erreicht werden. Für Anwendungen mit Schutzfunktionen ist dies erstmalig möglich. Da die einzelnen Schaltmodule aufgrund der steuerbaren bzw. regelbaren Stromaufteilung auf die einzelnen Schaltmodule gut in ihrer Leistungsfähigkeit ausgenutzt werden, sind elektronische Schalter mit hohen Schaltströmen besonders preisgünstig herstellbar. Die Kosten für eine Geräteparallelschaltung können durch die hohe Ausnutzung der Schaltmodule reduziert werden. Dabei können diese einzelnen Schaltmodule beliebig parallelgeschaltet werden, so dass sich hieraus modular ein elektronischer Schalter aufbauen lässt, der einen großen Leistungsbereich abdeckt. Der Anteil an Gleichteilen ist damit besonders hoch und gleichzeitig ist der Schalter besonders gut skalierbar. Dies macht den modularen elektronischen Schalter bei der Herstellung, Lagerhaltung, im Ersatzteilgeschäft usw. besonders kostengünstig.

Durch aktive Beeinflussung des Durchlassverhaltens (beispielsweise mittels der Gate-Spannung) kann der Gesamtstrom gesteuert oder geregelt auf die einzelnen Schaltmodule aufgeteilt werden. Somit kann jedes Schaltmodul bis an seine Belastungsgrenze ausgenutzt werden.

Bei einer vorteilhaften Ausgestaltung der Erfindung sind die Schaltmodule baugleich ausgeführt. Auch elektronische Schalter mit großer Schaltströmen lassen sich kostengünstig auf Basis von standardisierten Schaltmodulen aufbauen. Es können dabei aus gleichen Schaltmodulen eine Vielzahl von elektronischen Schaltern mit unterschiedlichen Leistungsfähigkeit hergestellt werden. Diese standardisierten Schaltmodule können in hoher Stückzahl kostengünstig und qualitativ hochwertig produziert werden. Dies führt zu großen Einspareffekten bei der Bereitstellung und Lagerhaltung von elektronischen Schaltern unterschiedlicher Schaltströme und ermöglicht auch, selbst Schalter für hohe Ströme wirtschaftlich anbieten zu können. Viele Gleichteile und die gute Skalierbarkeit, geringe Lagerhaltungskosten, da keine unterschiedlichen Leistungsklassen mit unterschiedlichen Schaltern vorgehalten werden müssen, senken die Kosten deutlich für den modularen elektronischen Schalter im Vergleich zu einem mechanischen oder nichtmodularen Schalter. Wenn die Schaltmodule alle baugleich ausgeführt sind, erhöht sich die Anzahl der Gleichteile weiter und führt so zu kostengünstigen Lösungen aufgrund des gesteigerten Mengeneffekts.

Bei einer weiteren vorteilhaften Ausgestaltung der Erfindung unterscheiden sich die Schaltmodule durch die Leistungsfähigkeit der jeweiligen Halbleiterschalter. Durch Schaltmodule, die jeweils Halbleiterschalter mit unterschiedlicher Leistungsfähigkeit, insbesondere unterschiedlicher Stromtragfähigkeit, aufweisen, lässt sich mit wenigen parallel angeordneten Schaltmodulen ein breites Leistungsspektrum an elektronischen Schaltern mit unterschiedlicher Leistungsfähigkeit, d.h. mit unterschiedlichen Strömen, erzeugen. Auch wenn sich die Halbleiterschalter in ihrer Leistungsfähigkeit unterscheiden, können die Schaltmodule noch einen hohen Anteil an Gleichteilen aufweisen, da auch für unterschiedliche Halbleiterschalter gleiche Ansteuerschaltungen und gleiche Datenschnittstellen verwendet werden können. Damit wird ein guter wirtschaftlicher Kompromiss zwischen Gleichteilen und erforderlicher Anzahl paralleler Schaltmodule erzielt.

Bei einer weiteren vorteilhaften Ausgestaltung der Erfindung ist eine Verdrahtung zur elektrischen Verbindung der Schaltmodule unsymmetrisch ausgeführt. Durch die gesteuerte oder geregelte Aufteilung des Stroms durch den elektronischen Schalter auf die parallelen Schaltmodule kann ein Aufwand für eine möglichst symmetrische Verdrahtung entfallen. Diese symmetrische Verdrahtung ist bei einer Parallelschaltung von mechanischen Schaltern erforderlich, um einer Ungleichverteilung bei der Aufteilung des Stroms auf die einzelnen parallelen Schalter entgegenzuwirken. Diese symmetrische Verdrahtung ist teuer und erfordert Einbauplatz. Anders formuliert, kann bei der Parallelschaltung von Schaltmodulen auf eine symmetrische Verdrahtung verzichtet werden. Dadurch lässt sich Material für die Ausbildung der Verdrahtung, wie teures Kupfer, sparen. Dies ermöglicht darüber hinaus auch einen höherer Freiheitsgerad in der räumlichen Anordnung der Schaltmodule, da diese nicht von der symmetrischen Verdrahtung abhängt. Somit entfallen die Aufwendungen für eine symmetrische Verdrahtung sowie Randbedingungen für die räumliche Anordnung der Schaltmodule, da auch diese Unterschiede mittels Steuerung der Durchlasswiderstände der Halbleiterschalter ausgeglichen werden können.

Bei einer weiteren vorteilhaften Ausgestaltung der Erfindung wird die Aufteilung des Stroms auf die Halbleiterschalter derart gesteuert oder geregelt, dass die Auslastung der Halbleiterschalter gleich ist. Die Auslastung ist das Verhältnis vom Strom, der durch den Halbleiterschalter fließt und dem zulässigen Strom durch den Halbleiterschalter. Bei baugleichen Halbleiterschaltern ist die gleiche Auslastung mit einem gleichen Strom gleichzusetzen. Hat hingegen ein Halbleiterschalter einen doppelt so hohen zulässigen Strom wie ein anderer Halbleiterschalter, so ist bei gleicher Auslastung der Strom durch diesen Halbleiterschalter auch doppelt so groß wie der Strom durch den anderen Halbleiterschalter. Durch die gleiche Auslastung wird die Belastung für die einzelnen Schaltmodule möglichst gering und gleich gehalten, so dass die sich aus diesem Betrieb die Lebensdauer des elektronischen Schalters optimieren lässt. Darüber hinaus lässt sich die Information über die Auslastung auf einfache Weise durch Normierung des Messwertes des Stromsensors ermitteln.

Bei einer weiteren vorteilhaften Ausgestaltung der Erfindung werden die für die Aufteilung des Stroms erforderlichen Parameter ermittelt und gespeichert. Damit sich die gewünschte Stromaufteilung durch die Steuerung oder Regelung schnell und korrekt einstellt und kein Halbleiterschalter beim Schaltvorgang zu sehr belastet wird, was erst durch die Regelung wieder ausgeglichen wird, hat es sich als vorteilhaft erwiesen, Parameter zu bestimmen und abzuspeichern, bei denen sich der Strom schon nahezu gewünscht auf die parallelen Schaltmodule aufteilt. Diese Parameter berücksichtigen Unterschiede in den Halbleiterschalter der unterschiedlichen Schaltmodule. Diese Parameter können dann als Startpunkt für das erstmalige Schalten des elektronischen Schalters verwendet werden, da damit schon eine optimierte Aufteilung des Stroms auf die Schaltmodule erreicht wird. Die genaue Aufteilung wird dann mit Wirken der Regelung oder Steuerung erreicht.

Diese initiale Messung kann dabei sowohl automatisiert oder auch beispielsweise durch das Inbetriebsetzungspersonal von Hand vorgenommen werden. Somit ist sichergestellt das auch bei extremen Ungleichverteilungen aufgrund von Bauteilstreuungen und/oder einer unsymmetrischen Verdrahtung sich zum Schaltzeitpunkt, insbesondere beim erstmaligen Schalten, schon eine hinreichend gute Stromaufteilung ergibt.

Im Folgenden wird die Erfindung anhand der in den Figuren dargestellten Ausführungsbeispiele näher beschrieben und erläutert. Es zeigen:
- FIG 1: ein Schaltmodul und
- FIG 2: einen elektronischen Schalter mit Schaltmodulen.

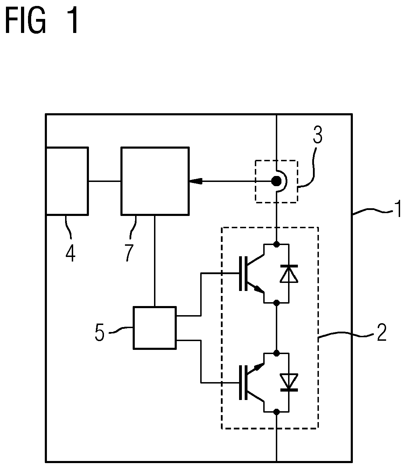

Die FIG 1 zeigt ein Schaltmodul 1, das für die Verwendung in einem modularen elektronischen Schalter 10 geeignet ist. Das Schaltmodul 1 weist einen Halbleiterschalter 2, einen Stromsensor 3, eine Datenschnittstelle 4, eine Ansteuerschaltung 5 und eine Regelung 7 auf. Mit Hilfe des Stromsensors 3 und/oder Daten, die über die Datenschnittstelle von 4 anderen, parallel angeordneten Schaltmodulen 1 übertragbar sind, steuert oder regelt die Regelung 7 den Strom durch das Schaltmodul. Als Stellglied dient dabei das Durchlassverhalten des Halbleiterschalters 2, das mit der Ansteuerschaltung 5 beeinflussbar ist. Dazu tauscht die Regelung 7 mit der Datenschnittstelle 4 Daten aus und/oder empfängt Messwerte vom Stromsensor 3. Der Ausgang der Regelung 7 ist mit der Ansteuerschaltung 5 verbunden, um die Regelungsaufgabe an dem Halbleiterschalter 2 umzusetzen.

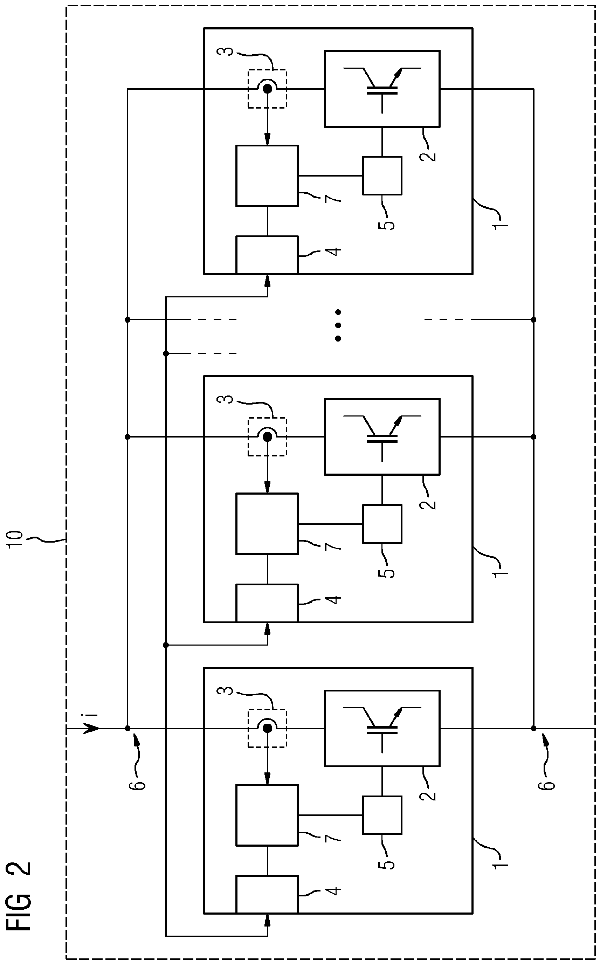

Die FIG 2 zeigt einen elektronischen Schalter 10, der aus einer Vielzahl von parallel angeordneten Schaltmodulen 1 aufgebaut ist. Zum Aufbau eines modularen elektronischen Schalters 10 können zwei oder mehr Schaltmodule 1 verwendet werden. Die einzelnen Schaltmodule entsprechen beispielsweise dem Ausführungsbeispiel der FIG 1. Diese können baugleich sein oder sich unterscheiden. Beispielsweise können sich die Schaltmodule 1 in der Leistungsfähigkeit des Halbleiterschalters 2 unterscheiden. Damit ist es möglich, elektronische Schalter 1 mit unterschiedlichen Schaltströmen mit nur wenigen, parallel angeordneten Schaltmodulen 1 zu realisieren. Dies Schaltmodule 1 sind zum Datenaustausch über ihre Datenschnittstelle 4 miteinander verbunden. Dabei kann die Datenschnittstelle 4 als digitale oder analoge Datenschnittstelle 4 ausgebildet sein. Durch die übertragenen Daten können die Regelungen 7 der einzelnen Schaltmodule 1 die Aufteilung des Stroms i auf die einzelnen Schaltmodule steuern oder regeln. Dabei können verschiedene Optimierungskriterien für die Aufteilung des Stroms i herangezogen werden. Durch die Regelungen 7 wird sichergestellt, dass kein Schaltmodul 1 mit einem unzulässig hohen Strom durchflossen wird.

Dabei kann die Verdrahtung 6 des elektronischen Schalters 10, welche die Halbleiterschalter 2 der Schaltmodule 1 parallel miteinander verbindet, unsymmetrisch, auch als asymmetrisch bezeichnet, ausgeführt sein. So ist beispielsweise die Leitungslänge im dargestellten Ausführungsbeispiel für die Verbindung des linken Schaltmoduls 1 am geringsten und nimmt mit jedem Schaltmodul 1 von links nach rechts zu.

Alternativ zu den in den Figuren 1 und 2 dargestellten Ausführungsbeispielen ist es auch möglich, anstelle der einzelnen Regelungen 7 der jeweiligen Schaltmodule 1 eine zentrale Regelung für den elektronischen Schalter 10 vorzusehen. Ebenso können alternativ die Aufgaben der Regelung 7 durch die Ansteuerschaltung durchgeführt werden. Der Datenaustausch zwischen der zentralen Regelung und den Ansteuerschaltungen 5 kann dann beispielsweise auch über die Datenschnittstelle 4 erfolgen.

Zusammenfassend betrifft die Erfindung ein Schaltmodul und einen elektronischen Schalter. Zur Verbesserung des elektronischen Schalters wird vorgeschlagen, dass der elektronische Schalter mindestens zwei Schaltmodule aufweist. Die Schaltmodule weisen dabei einen Halbleiterschalter mit einer Ansteuerschaltung, einen Stromsensor und eine Datenschnittstelle zur Verbindung mit einem weiteren Schaltmodul auf, wobei mittels der Ansteuerschaltung in Abhängigkeit von über die Datenschnittstelle ausgetauschten Daten und/oder in Abhängigkeit von Messwerten des Stromsensors der Durchlasswiderstand des Halbleiterschalters veränderbar ist. Bei dem elektronischen Schalter mit mindestens zwei derartigen Schaltmodulen sind die Schaltmodule derart parallel zueinander angeordnet, dass die Halbleiterschalter elektrisch parallel zueinander angeordnet sind und dass ein Strom durch den elektronische Schalter sich auf die Halbleiterschalter der Schaltmodule aufteilt, wobei die Datenschnittstellen der jeweiligen Schaltmodule miteinander verbunden sind, wobei mittels der Ansteuerschaltungen durch Veränderung des jeweiligen Durchlasswiderstands der Halbleiterschalter eine Aufteilung des Stroms durch den elektronischen Schalter auf die Halbleiterschalter beeinflussbar, insbesondere steuerbar und/oder regelbar, ist. Die Erfindung betrifft ferner ein Verfahren zum Betreiben eines derartigen elektronischen Schalters.

## Patentansprüche

1. Schaltmodul (1), aufweisend
- einen Halbleiterschalter (2) mit einer Ansteuerschaltung (5),
- einen Stromsensor (3) und
- eine Datenschnittstelle (4) zur Verbindung mit einem weiteren Schaltmodul (1),
wobei mittels der Ansteuerschaltung (5) in Abhängigkeit von über die Datenschnittstelle ausgetauschten Daten und/oder in Abhängigkeit von Messwerten des Stromsensors (3) der Durchlasswiderstand des Halbleiterschalters (2) veränderbar ist.

2. Elektronischer Schalter (10) mit mindestens zwei Schaltmodulen (1) nach Anspruch 1,
wobei die Schaltmodule (1) derart parallel angeordnet sind, dass die Halbleiterschalter (2) elektrisch parallel angeordnet sind und dass ein Strom (i) durch den elektronische Schalter (10) sich auf die Halbleiterschalter (2) der Schaltmodule (1) aufteilt, wobei die Datenschnittstellen (4) der jeweiligen Schaltmodule (1) miteinander verbunden sind, wobei mittels der Ansteuerschaltungen (5) durch Veränderung des jeweiligen Durchlasswiderstands der Halbleiterschalter (2) eine Aufteilung des Stroms (i) durch den elektronischen Schalter (10) auf die Halbleiterschalter (2) beeinflussbar, insbesondere steuerbar und/oder regelbar, ist.

3. Elektronischer Schalter (10) nach Anspruch 2, wobei die Schaltmodule (1) baugleich ausgeführt sind.

4. Elektronischer Schalter (10) nach Anspruch 2, wobei sich die Schaltmodule (1) durch die Leistungsfähigkeit der jeweiligen Halbleiterschalter (2) unterscheiden.

5. Elektronischer Schalter (10) nach einem der Ansprüche 2 bis 4, wobei eine Verdrahtung (6) zur elektrischen Verbindung der Schaltmodule (1) unsymmetrisch ausgeführt ist.

6. Verfahren zum Betreiben eines elektronischen Schalters (10) nach einem der Ansprüche 2 bis 5,
wobei in Abhängigkeit von über die Datenschnittstelle (4) ausgetauschten Daten und/oder in Abhängigkeit von Messwerten der Stromsensoren (3) der Durchlasswiderstand der Halbleiterschalter (2) derart gesteuert oder geregelt wird, dass sich der Strom (i) durch den elektronischen Schalter (10) derart auf die Halbleiterschalter (2) aufteilt, dass die jeweiligen Halbleiterschalter (2) maximal den jeweils zulässigen Strom führen.

7. Verfahren nach Anspruch 6, wobei die Aufteilung des Stroms (i) auf die Halbleiterschalter (2) derart gesteuert oder geregelt wird, dass die Auslastung der Halbleiterschalter (2) gleich ist.

8. Verfahren nach einem der Ansprüche 6 oder 7, wobei die für Aufteilung des Stroms (i) erforderlichen Parameter ermittelt und gespeichert werden.
